Europäisches Patentamt

(19) European Patent Office

Office européen des brevets

(11) Numéro de publication: **0 138 098**
**B1**

(12) **FASCICULE DE BREVET EUROPEEN**

(45) Date de publication du fascicule du brevet:
**05.08.87**

(21) Numéro de dépôt: **84111279.0**

(22) Date de dépôt: **21.09.84**

(51) Int. Cl.⁴: **G 04 G 1/00,** G 02 F 1/13

(54) Dispositif électronique pour élaborer et afficher une information, procédé d'assemblage de ce dispositif et machine pour la mise en oeuvre du procédé.

(30) Priorité: **14.10.83 CH 5610/83**

(43) Date de publication de la demande:
**24.04.85 Bulletin 85/17**

(45) Mention de la délivrance du brevet:
**05.08.87 Bulletin 87/32**

(84) Etats contractants désignés:
**DE FR GB**

(56) Documents cités:
**FR - A - 2 340 666**
**US - A - 4 183 629**

**ELECTRONICS, vol. 49, no. 7, 15 avril 1976, page 29, New York, US; "Reels of film automate watch module assembly"**
**PATENTS ABSTRACTS OF JAPAN, vol. 2, no. 94, 5 août 1978, page 4391E78; & JP - A - 53 57874 (SUWA SEIKOSHA K.K.) 25-05-1978**
**PATENTS ABSTRACTS OF JAPAN, vol. 1, no. 135, 9 novembre 1977, page 6252E77; & JP - A - 52 69646 (SUWA SEIKOSHA K.K.) 09-06-1977**
**PATENTS ABSTRACTS OF JAPAN, vol. 7, no. 26(P-172)[1171], 2 février 1983; & JP - A - 57 178 220 (RICOH K.K.) 02-11-1982**

(73) Titulaire: **ETA S.A., Fabriques d'Ebauches, Schild-Rust-Strasse 17, CH-2540 Granges (CH)**

(72) Inventeur: **Thomke, Ernst, Allerheiligenstrasse 210, CH-2540 Granges (CH)**
Inventeur: **Zaugg, Hans, Meisenweg, CH-4552 Derendingen (CH)**

(74) Mandataire: **de Montmollin, Henri et al, ICB Ingénieurs Conseils en Brevets SA Faubourg du Lac 6, CH-2501 Bienne (CH)**

## Description

La présente invention a pour objet un dispositif électronique pour élaborer et afficher une information, un procédé d'assemblage de ce dispositif et une machine pour la mise en oeuvre de ce procédé.

Un dispositif du genre mentionné ci-dessus comporte essentiellement un ensemble électronique destiné à fournir une information, une cellule d'affichage reliée à l'ensemble électronique pour afficher l'information, et une source d'énergie électrique alimentant l'ensemble électronique.

Un tel dispositif peut constituer, par exemple, une pièce d'horlogerie électronique à affichage numérique ou pseudo-analogique. Dans ce cas, l'ensemble électronique comporte un circuit de base de temps formé par un oscillateur et un diviseur de fréquence, ainsi que des compteurs qui fournissent des informations horaires en réponse aux signaux fournis par le circuit de base de temps. La cellule d'affichage est alors agencée de manière à afficher ces informations horaire qui comportent en général au moins l'heure et la minute du temps réel. Très souvent, l'ensemble électronique et la cellule d'affichage sont agencés de manière que la seconde de temps réel soit en outre affichée, ainsi que d'autres informations telles que par exemple la date, le jour de la semaine, un temps chronométré ou une heure d'alarme.

Il sera évident à la lecture de la description qui va suivre que l'invention n'est pas limitée au cas où le dispositif est une pièce d'horlogerie, mais qu'elle peut être adaptée sans difficulté à tous les cas où une information est élaborée par un esemble électronique pour être affichée par une cellule d'affichage.

Les dispositifs de ce genre connus jusqu'ici comportent généralement un boîtier rigide, en métal ou en plastique, dans lequel sont montés la cellule d'affichage, l'ensemble électronique et la source d'énergie électrique qui est généralement une pile. Ces éléments sont réunis mécaniquement par un cadre logé dans le boîtier, et ils sont reliés électriquement par des éléments de connexion.

Le boîtier est généralement fermé par un fond et une glace à travers laquelle la cellule d'affichage est visible. Enfin, des organes de commande manuelle, par exemple des boutons-poussoir, sont souvent montés sur le boîtier pour permettre la commande des différentes fonctions du dispositif, telles que la fonction de mise à l'heure si ce dispositif est une pièce d'horlogerie.

Malgré toutes les simplifications qui ont été apportées à la contruction et à la fabrication de ces dispositifs, celles-ci sont encore assez compliquées et ne permettent donc pas de produire ces dispositifs à très bas prix. En outre, les dispositifs connus sont généralement fragiles et non étanches, à moins que des mesures spéciales ne soient prises. Ces mesures spéciales augmentent bien entendu le prix de revient de ces dispositifs.

Enfin, ces dispositifs connus sont relativement lourds, notamment lorsque leur boîtier est métallique, et ils ont une épaisseur assez importante.

Un but de la présente invention est de fournir un dispositif du genre défini ci-dessus qui soit à la fois très bon marché, léger, étanche, peu fragile, de faible épaisseur et souple.

D'autres buts de la présente investition sont de fournir un procédé d'assemblage de ces dispositifs et une machine pour la mise en oeuvre de ce procédé.

Ces buts sont atteints par le dispositif, le procédé d'assemblage et la machine revendiqués.

L'invention va maintenant être décrite à l'aide du dessin dans lequel:

la fig. 1 est une vue d'ensemble d'une forme d'exécution du dispositif selon l'invention;

la fig. 2 est une vue éclatée du dispositif de la fig. 1;

la fig. 3 est une coupe partielle du dispositif de la fig. 1;

la fig. 4 représente schématiquement une machine d'assemblage de dispositifs selon l'invention;

la fig. 5 représente des dispositifs assemblés à l'aide de la machine de la fig. 4;

la fig. 6 représente un autre ensemble de dispositifs assemblés; et

les figures 7 et 8 représentent d'autres formes d'exécution du dispositif selon l'invention.

Il faut noter que, dans ces figures, les divers éléments du dispositif ont été représentés avec des épaisseurs choisies arbitrairement grandes pour simplifier la compréhension du dessin.

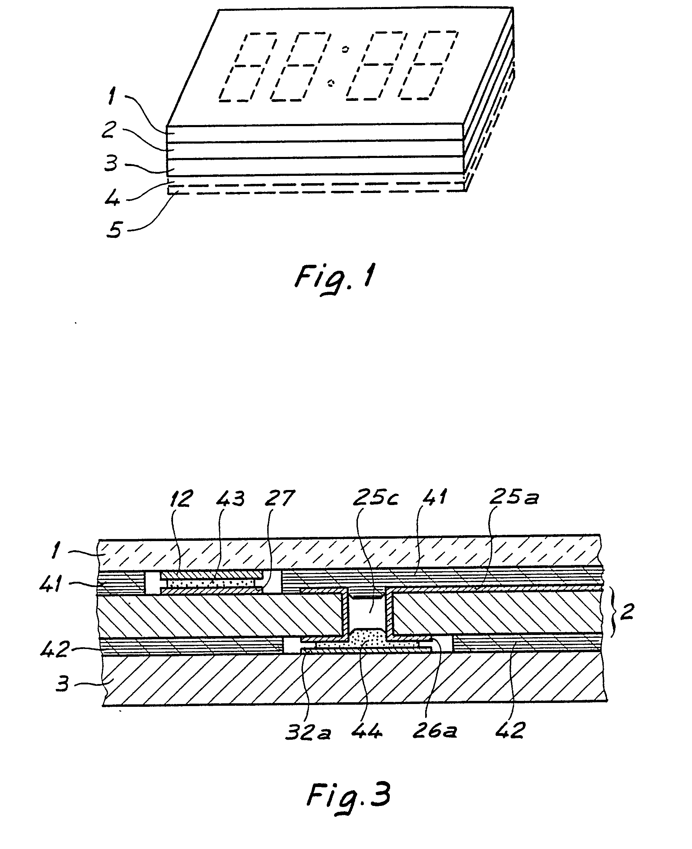

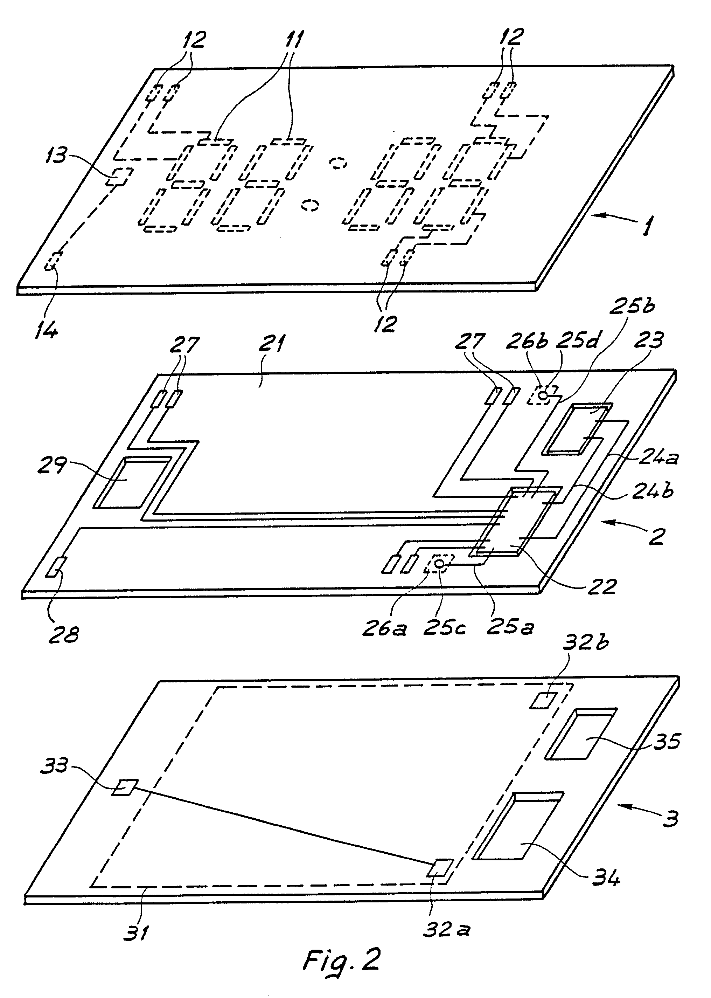

Le dispositif représenté, à titre d'exemple non limitatif, en vue d'ensemble à la fig. 1 et en vue éclatée à la fig. 2, est une pièce d'horlogerie électronique. Il comporte une cellule d'affichage 1, un ensemble électronique 2 et une source d'énergie électrique 3.

Dans la suite de cette description, les faces de ces éléments 1, 2 et 3, ainsi que celles des éléments 1', 2' et 3' qui seront mentionnés plus loin, seront désignées par «supérieure» ou «inférieure» selon qu'elles sont tournées vers le haut ou vers le bas dans les figures, indépendamment de la position de ces faces dans le dispositif terminé et fixé à l'emplacement où il doit être utilisé.

Ainsi, la face supérieure et la face inférieure de la cellule 1 sont celles qui sont respectivement tournées vers l'extérieur du dispositif et vers l'ensemble électronique 2; les faces supérieure et inférieure de cet ensemble électronique 2 sont respectivement tournées vers la cellule 1 et vers la source d'énergie électrique 3; enfin, les faces supérieure et inférieure de cette source 3 sont respectivement tournées vers l'ensemble électronique 2 et vers l'extérieur du dispositif.

La cellule d'affichage 1 est du même genre que celle qui a été décrite dans la communication no 31 faite au 56ème Congrès de la Société Suisse de Chronométrie des 23 et 24 october 1981 par MM. Kikuyama et al. ou dans la demande de brevet britannique no 2 052 779.

Cette cellule 1 est une cellule d'affichage à cristal liquide tout à fait classique, à la seule différence près que les deux plaques qui la délimitent et qui entourent la couche de cristal liquide sont constituées par des films minces de matière plastique, par exemple un polyester ou un autre polymère. De ce fait, la cellule 1 est très mince, et elle possède une certaine souplesse qui lui permet d'être déformée sans dommage et sans cesser de fonctionner. A titre d'exemple, une telle cellule peut avoir une épaisseur totale de 0,2 mm environ.

Le film constituant la face supérieure de la cellule est bien sûr transparent, alors que l'autre film peut être, selon les cas, transparent ou opaque. Ces deux films, ainsi que la couche de cristal liquide n'ont pas été représentés séparément pour ne pas charger inutilement le dessin.

La cellule 1 comporte, de manière classique, des électrodes qui sont disposées sur les faces internes des deux films de matière plastique.

Sur l'un de ces films, les électrodes ont chacune la forme de l'un des éléments d'affichage qui doivent être rendus visibles ou invisibles pour former les divers chiffres, lettres ou autres signes devant être affichés. Ces électrodes sont communément appelées électrodes de commande, et elles ont été représentées en pointillé dans les figures 1 et 2 car elles sont normalment invisibles. Quelques-unes de ces électrodes de commande ont été désignées par la référence 11 dans la fig. 2.

L'autre film ne porte généralement qu'une électrode qui est située en regard de toutes les électrodes de commande et qui est communément appelée contre-électrode. Cette contre-électrode n'a pas été représentée pour ne pas alourdir inutilement le dessin.

La cellule d'affichage 1 pourrait également comporter plusieurs contre-électrodes isolées les unes des autres, plusieurs électrodes de commande situées chacune en regard d'une autre contre-électrode étant alors reliées électriquement. Un dispositif muni d'une telle cellule d'affichage ne sortirait évidemment pas du cadre de l'invention.

Les électrodes de commande 11 et la contre-électrode sont reliées à l'extérieur de la cellule d'affichage 1 par des pistes conductrices et par des bornes de connexion disposées sur la face inférieure de la cellule 1 et donc normalement invisibles dans la fig. 2. Dans cette fig. 2, quelques-unes de ces pistes et de ces bornes de connexion ont été représentées en pointillé, les bornes étant désignées par la référence 12.

Dans l'exemple de ces figures 1 et 2, les électrodes de commande sont disposées de manière classique pour que la cellule 1 puisse afficher une information horaire sous forme numérique par quatre chiffres, et une information auxiliaire par deux points situés entre les deux chiffres du centre. Les deux chiffres de gauche servent à afficher les heures, les deux chiffres de droite les minutes, et les deux points clignotent, par exemple, à une fréquence de 1 Hz.

Il est évident que, dans d'autres dispositifs selon l'invention, les électrodes de commande de la cellule 1 pourraient être disposées différemment, de manière à permettre d'afficher des informations horaires, ou d'autres genres d'informations, sous une forme quelconque, numérique ou non.

Ces électrodes pourraient notamment être disposées parallèlement les unes aux autres, ou selon les rayons d'un ou de plusieurs cercles, de manière à permettre d'afficher une information sous une forme pseudo-analogique.

Dans l'exemple de la fig. 2 la cellule d'affichage 1 est en outre munie d'une plage de contact 13, située sur sa face inférieure, qui est reliée électriquement à une borne de connexion 14 également située sur cette même face inférieure. Le rôle de cette plage de contact 13 sera décrit plus loin.

L'ensemble électronique 2 des figures 1 et 2 comporte un circuit imprimé comprenant un substrat isolant souple 21 sur lequel sont déposées, de manière bien connues, des pistes conductrices. Pour ne pas nuire à la clarté du dessin, seules quelques-unes de ces pistes conductrices ont été représentées à la fig. 2.

L'ensemble électronique 2 comporte en outre un circuit intégré 22 et un résonateur piézo-électrique 23. Dans le présent exemple, le circuit intégré 22 est agencé de manière à réaliser les fonctions de mesure du temps désirées. Il contient notamment un circuit oscillateur destiné à être relié au résonateur 23 pour constituer le circuit de base de temps de la pièce d'horlogerie.

Les divers circuits électroniques réalisés dans le circuit intégré 22 ne seront pas décrits ici, car ils sont tout à fait classiques et n'ont pas de rapport avec la présente invention. Ces circuits électroniques sont d'ailleurs différents selon le genre d'informations que le dispositif selon l'invention doit élaborer et afficher. Le résonateur 23 pourrait en outre ne pas exister, ou être remplacé par un ou plusieurs autres composants tels qu'un capteur de température, de pression ou autre.

Dans le présent exemple, le circuit intégré 22 et le résonateur piézo-électrique 23 sont logés dans des ouvertures ménagées dans le substrat isolant 21, de manière que leur face supérieure, qui porte leurs bornes de connexion, non représentées, soit située sensiblement dans le même plan que la face supérieure du substrat 21.

Le circuit intégré 22 comporte, de manière classique, une plaquette de silicium dans laquelle sont formés les divers composants électroniques, principalement des transistors. La plaquette de silicium est enrobée dans une couche de protection généralement en verre, dont la face supérieure est percée d'ouvertures dans lesquelles sont disposées les bornes de connexion du circuit intégré.

Le résonateur piézo-électrique 23 comporte, de manière également classique, un élément résonateur en quartz encapsulé dans un boîtier plat en céramique ou en verre. Ce boîtier porte également sur sa face supérieure les deux bornes de connexion du résonateur. Comme le circuit intégré 22 et le résonateur 23 sont plus épais que le substrat 21, ils dépassent de la face inférieure de celui-ci.

Les pistes conductrices du circuit imprimé ont été disposées sur le substrat de manière qu'une de leurs extrémités soit située à l'intérieur de l'emplacement des ouvertures destinées à recevoir le circuit intégré 22 et le résonateur 23. Ces ouvertures ont ensuite été découpées de manière que ces extrémités subsistent et dépassent les bords de ces ouvertures. Ces extrémités des pistes conductrices sont soudées, par exemple par thermo-compression, aux bornes du circuit intégré 22 et du résonateur 23 après mise en place de ces derniers dans les ouvertures du substrat 21. Cette technique est bien connue sous son nom anglais de «Tape Automated Bonding» (TAB) et ne sera pas décrite ici plus en détail.

Deux des pistes conductrices, désignées par les références 24a et 24b, relient le résonateur 23 aux bornes du circuit intégré 22 qui, dans celui-ci, sont reliées au circuit oscillateur.

Deux autres pistes conductrices, désignées par les références 24a et 25b, ont leur première extrémité aux bornes d'alimentation du circuit intégré 22 et leur deuxième extrémité reliée à des trous métallisés 25c et 25d qui traversent le substrat 21. La métallisation des trous 25c et 25d est reliée, sur la face inférieure du substrat 21, à des bornes de connexion 26a et 26b.

D'autres pistes conductrices du circuit imprimé relient d'autres bornes du circuit intégré 22 à des bornes de connexion situées en regard des bornes de connexion de la cellule d'affichage 1. Seules quelques-unes de ces pistes conductrices ont été représentées, et les bornes de connexion correspondantes sont designées par la référence 27.

Enfin, une des bornes du circuit intégré, dont le rôle sera décrit plus loin, est reliée, toujours par une piste conductrice, à une borne de connexion 28 située en regard de la borne 14 de la cellule 1.

Il est évident que le circuit intégré 22, les pistes conductrices qui relient ses bornes aux bornes de connexion 27 et 28, les bornes de connexion 12 de la cellule 1 ainsi que les pistes conductrices qui les relient aux électrodes 11 sont agencés et disposés de manière que la cellule 1 affiche correctement l'information élaborée par le circuit intégré 22. En outre, les diverses bornes de connexion qui sont disposées à la périphérie des éléments 1 et 2 dans l'exemple de la fig. 2, pourraient être disposées ailleurs sur les faces inférieure et, respectivement, supérieure de ces éléments.

Enfin, le substrat 21 est percé d'une ouverture 29 disposée en regard de la plage conductrice 12 de la cellule 1. Le rôle de cette ouverture 29 sera décrit plus loin.

L'ensemble électronique 2 décrit ci-dessus est très mince. Le substrat 21 a une épaisseur de 0,2 à 0,3 mm, et le circuit intégré 22 et le résonateur 23 ont des épaisseurs de 1,5 mm environ. Ces derniers ne dépassent donc la face inférieure du substrat que de 1,2 à 1,3 mm. Le substrat 21 étant souple, l'ensemble électronique 2 l'est également.

La source d'énergie électrique 3 est constituée par une pile plate qui comporte, par exemple, une plaque positive en acier inoxydable, une plaque négative en zinc et un électrolyte, du perchlorate de zinc dans cet exemple, contenu dans un séparateur poreux disposé entre les deux plaques. Une telle pile a été décrite notamment à la page 86 du no 11 de l'année 1979 de la revue «Funkschau».

Les plaques et l'électrolyte de cette pile sont disposés entre deux feuilles minces de matière plastique ou de carton qui sont soudées ou collées l'une à l'autre à leur périphérie. Ces feuilles, ces plaques et cet électrolyte n'ont pas été représentés séparément pour ne pas charger inutilement le dessin. L'emplacement des plaques est représenté schématiquement par un cadre 31 dessiné en pointillés à la fig. 1.

Les bornes positive et négative 32a et 32b de la pile sont disposées sur la face supérieure de celle-ci, en regard des bornes de connexion 26a et 26b de l'ensemble électronique 2.

La face supérieure de la pile porte également une plage conductrice 33 disposée en regard de la plage conductrice 12 de la cellule d'affichage 1. Cette plage conductrice 33 est reliée à la borne 32a de la pile 3 par une piste conductrice.

Enfin, les feuilles qui entourent les composants de la pile 3 sont percées de deux ouvertures 34 et 35 ayant les mêmes dimensions que les ouvertures ménagées dans le substrat 21 de l'ensemble électronique 2 dans lesquelles sont logés le circuit intégré 22 et le résonateur 23 et situées en regard de celles-ci. Ces ouvertures 34 et 35 sont évidemment situées à l'extérieur de la zone délimitée par le cadre 31 où se trouvent les composants actifs de la pile.

Tous les composants de la pile 3 étant très minces, celle-ci est également mince. Elle peut avoir, par exemple, une épaisseur inférieure à 1 mm. Une telle pile possède une certaine souplesse et peut être déformée sans cesser de fonctionner.

D'autres types de piles minces et souples sont connus, notamment par le livre intitulé «High Energy Batteries» de M. R. Jasinski, édité en 1967 par la maison Plenum Press à New York, USA (pages 233 à 237) ou par le livre intitulé «Power Sources 2» de MM. P. A. Boter et al. édité en 1968 par la maison Philips à Eindhoven, Pays-Bas (pages 364 et 365).

Lors de la fabrication de ces piles, l'électrolyte n'est généralement pas mis en contact directement avec les plaques positive et négative. Il peut être stocké dans une enceinte fermée en verre ou en matière plastique, disposée à un entroit adéquat dans la pile. Lorque celle-ci doit être mise en service, cette enceinte est rompue, par exemple, par une pression exercée sur la pile, ce qui libère l'électrolyte qui peut ainsi venir au contact des plaques.

La fabrication de la cellule d'affichage 1, de l'ensemble électronique 2 et de la source d'énergie électrique 3 en tant que tels, ne sera pas décrite ici car elle est bien connue et n'a pas de rapport direct avec la présente invention.

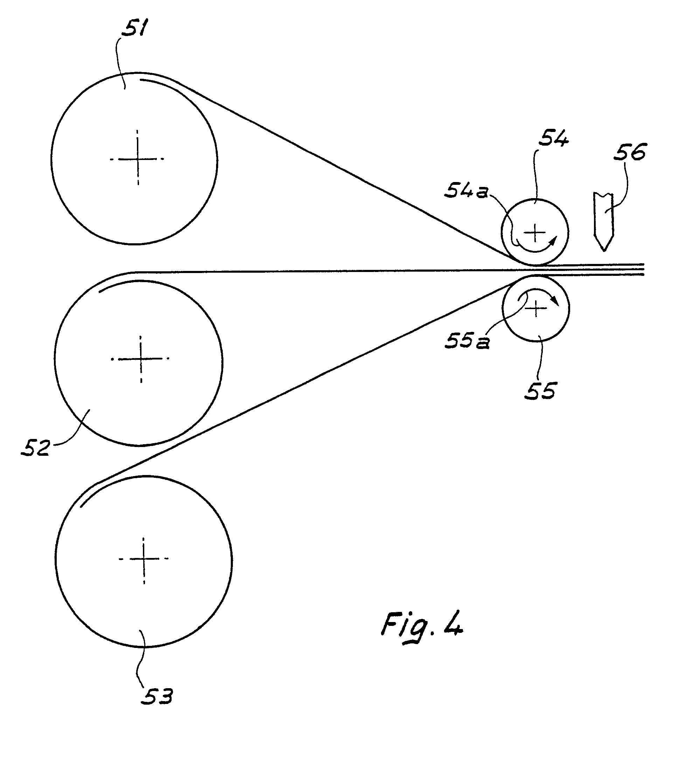

Une des manières possibles d'assembler la cellule d'affichage 1, l'ensemble électronique 2 et la source d'énergie électrique 3 pour réaliser le dispositif de la fig. 1 est illustrée par la fig. 3 à titre d'exemple non limitatif.

Cette fig. 3 est une vue en coupe partielle et schématique du dispositif de la fig. 1. Le plan de cette coupe, qui n'a pas été représenté, est perpendiculaire au plan des faces supérieure et inférieure du dispositif, parallèle au plus grand côté de ces faces et passe par l'axe du trou métallisé 25c de l'ensemble électronique 2.

Les éléments de cette fig. 3 qui sont également représentés dans les figures 1 et 2 sont désignés par les mêmes références que dans ces dernières.

Les détails de la cellule d'affichage 1, de l'ensemble électronique 2 et de la source d'énergie électrique 3 qui seraient normalement visibles dans cette fig. 3 mais qui ne jouent aucun rôle dans l'explication qui va suivre n'ont pas été représentés.

Dans cet exemple, des couches d'un premier matériau liquide ou pâteux destiné à être transformé par un traitement adéquat en un adhésif isolant solid sont déposées, par sérigraphie par exemple, sur la totalité des faces supérieure et inférieure de l'ensemble électronique 2, à l'exception des zones où sont situées les bornes de connexion 27, 28, 26a et 26b.

Ce premier matériau peut être constitué, par exemple, par le mélange d'une résine époxyde et de son durcisseur dans les proportions prescrites par leur fabricant.

Des couches d'un deuxième matériau liquide ou pâteux destiné à être transformé par un traitement adéquat en un adhésif conducteur solide sont ensuite déposées, également par sérigraphie, sur ces bornes de connexion 27, 28, 26a et 26b.

Ce deuxième matériau peut être constitué, par exemple, par le mélange d'une résine époxyde, de son durcisseur et d'une poudre métallique.

La cellule d'affichage 1 est ensuite appliquée contre la face superieure de l'ensemble électronique 2, de manière que ses bornes 12 et 14 viennent en regard des bornes 27, respectivement 28.

De même, la source d'énergie électrique 3 est appliqués contre la face inférieure de l'ensemble électronique 2, de manière que ses bornes 32a et 32b viennent respectivement en regard des bornes 26a et 26b et que le circuit intégré 22 et le résonateur 23 s'engagent dans les ouvertures 34 et 35.

L'ensemble ainsi constitué est ensuite mis dans les conditions nécessaires pour que les deux matériaux liquides ou pâteux déposés dans l'étape précédente se transforment en adhésifs solides isolants, désignés par les références 41 et 42, et, respectivement, en adhésifs solides conducteurs, désignés par les références 43 et 44. Ces conditions dépendent de la nature de ces adhésifs et sont prescrites par leurs fabricants.

Il est évident que ces adhésifs doivent être de préférence choisis de manière que leurs conditions de durcissement soient au moins sensiblement les mêmes, et qu'elles soient telles qu'elles n'entraînent pas la destruction de d'un ou l'autre des divers éléments du dispositif.

Après le durcissement des adhésifs, le dispositif selon l'invention est terminé, sans aucune autre opération de fabrication.

Les divers éléments du dispositif sont reliés mécaniquement par les couches 41 et 42 d'adhésif isolant, qui empêchent en outre tout contact non désiré entre les diverses pistes conductrices disposées sur ces éléments, et les diverses bornes de connexion sont reliées électriquement par les couches 43 et 44 d'adhésif conducteur.

Le dispositif ainsi constitué est très mince. A son endroit le plus épais, c'est-à-dire à l'emplacement du circuit intégré 22 et du résonateur 23, il a, par exemple, une épaisseur inférieure à 2 mm. Tous ses éléments étant souples, et les couches d'adhésif étant extrêmement minces, il est lui-même souple et peut être déformé sans cesser de fonctionner.

Ce dispositif est également très léger, étanche, et il supporte très bien les chocs. Enfin, son prix de revient est très bas.

Le fonctionnement du dispositif décrit ci-dessus dépend bien entendu du genre d'information que le circuit électronique 2 doit élaborer et que la cellule 1 doit afficher. Si la source d'énergie électrique 3 est déja en service au moment de l'assemblage du dispositif, celui-ci commence à fonctionner dès que les bornes 32a et 32b de cette source 3 sont reliées aux bornes 26a et 26b de l'ensemble électronique 2, et que les bornes 27 de cet ensemble électronique 2 sont reliées aux bornes 12 de la cellule d'affichage 1. Si la source 3 n'est pas encore en service au moment de l'assemblage du dispositif, celui-ci ne commence bien entendu pas à fonctionner à ce moment, mais seulement lorsque cette source 3 est activée, par exemple par rupture du récipient contenant son électrolyte.

Dans de nombreux cas, l'utilisateur du dispositif doit pouvoir corriger ou modifier manuellement l'information affichée.

Dans le cas du dispositif illustré par les figures 1 et 2, qui est une pièce d'horlogerie, le circuit intégré 22 est agencé de manière à réaliser une foction de mise à l'heure en réponse à des signaux appliqués à celle de ses bornes qui est reliée à la borne de connexion 28 de l'ensemble électronique 2.

Cette borne du circuit intégré 22 est reliée, dans ce dernier, à l'entrée d'un circuit de mise à l'heure du genre de celui qui est décrit, par exemple, par le brevet US no 3 953 964. Ce circuit de mise à l'heure, qui ne sera pas décrit en détail ici, est agencé de manière à sélectionner une des informations affichées et à modifier l'information sélectionnée en réponse au nombre et/ou à la durée d'application d'une tension de commande sur son entrée. Cette tension de commande est la tension de l'une des bornes de la source d'alimentation du circuit, par exemple la borne positive.

Dans le dispositif terminé, cette entrée du circuit de mise à l'heure est reliée à la plage de contact 13 par l'intermédiaire de la borne correspondante du circuit intégré 22, de la borne de connexion 28 et de la borne de connexion 14. Cette plage de contact est séparée de la plage de contact 33 disposée sur la souce d'énergie électrique 3 par une distance égale à l'épaisseur du substrat 21 de l'ensemble électronique 2.

Lorsque l'utilisateur appuie sur le dispositif dans la zone où se trouvent les plages 13 et 33, celles-ci entrent en contact grâce à la souplesse des divers éléments du dispositif et à la présence de l'ouverture 29. Comme la plage de contact 33 est reliée à la borne 32a de la source d'énergie électrique 3, la tension de cette borne 32a est donc appliquée à l'entrée du circuit de mise à l'heure du circuit intégré 22. Cette borne 32a est bien entendu celle qui délivre la tension nécessaire à la commande du circuit de mise à l'heure. Ce circuit de mise à l'heure exécute donc les fonctions pour lesquelles il est prévu en réponse aux pressions que l'utilisateur exerce sur le dispositif dans la zone des plages de contact 13 et 33.

Il serait possible de prévoir dans le circuit intégré 22 un circuit de mise à l'heure plus classique, comportant plusieurs entrées de commande, par exemple une entrée de sélection du chiffre à corriger et une entrée de correction proprement dite. Dans un tel cas, il suffirait par exemple d'agrandir la plage de contact 33, de disposer sur la cellule 1 le nombre voulu de plages de contact semblables à la plage 13, et de prévoir les pistes conductrices et les bornes de connexion correspondantes sur la cellule 1 et sur l'ensemble électronique 2. Le cas échéant, les dimensions de l'ouverture 29 devraient être modifiées, ou plusieurs ouvertures semblables à cette ouverture 29 devraient être prévues.

Dans les cas où ces moyens de correction ou de modification manuelle de l'information affichée ne sont pas nécessaires, comme par exemple lorsque le dispositif d'affichage est un thermomètre ou un baromètre, les plages de contact 13 et 33 ainsi que l'ouverture 29 sont bien entendu omises.

Il est évident que les opérations d'assemblage du dispositif selon l'invention peuvent être effectuées dans un ordre différent de celui qui a été décrit ci-dessus. Les couches 43 et 44 d'adhésif conducteur peuvent par exemple être déposées avant les couches 41 et 42 d'adhésif isolant. De même, ces couches peuvent être déposées tout d'abord sur une seule des faces de l'ensemble électronique 2, l'élément correspondant étant appliqué sur cette face avant que les couches d'adhésif ne soient déposées sur l'autre face. En outre, ces couches d'adhésif pourraient être déposées sur la face inférieure de la cellule d'affichager 1 et/ou sur la face supérieure de la source d'énergie électrique 3. Dans ce cas, aucun adhésif ne doit bien entendu être déposé sur les plages de contact 13 et/ou 33.

Il serait aussi possible de remplacer les couches 43 et 44 d'adhésif conducteur par des couches de matériau métallique fusible, de la soudure à l'étain par exemple, et de faire fondre ce matériau fusible pendant l'opération de durcissement des couches d'adhésif 41 et 42, ou indépendamment de ce durcissement.

La fixation du dispositif à l'emplacement où il doit être utilisé peut être faite de plusieurs manières.

Il est possible, par exemple, de prévoir des trous qui se correspondent dans chacun des trois éléments du dispositif, et qui permettent de le fixer à un bracelet, une chaînette ou autre. Il est également possible de donner aux trois éléments du dispositif la forme générale d'un bracelet, et de prévoir, aux extrémités de celui-ci, des moyens classiques de fermeture. Grâce à la souplesse des feuilles de matière plastique et/ou de carton qui constituent les supports de ces éléments, ce dispositif en forme de bracelet peut être porté comme une montre-bracelet classique.

Il est également possible de déposer sur la face inférieure d'un dispositif semblable à celui qui est représenté par les figures 1 et 2 une couche d'un matériau adhésif autocollant protégée par une feuille de papier ou de plastique. Au moment de l'emploi, il suffit d'enlever la feuille de protection et d'appliquer le dispositif à l'endroit voulu. Cette couche de matériau adhésif autocollant et sa feuille de protection ont été représentées en pointillé à la fig. 1, avec les références 4 et 5 et des épaisseurs choisies arbitrairement grandes.

La fabrication de chacun des éléments du dispositif, à savoir la cellule d'affichage 1, l'ensemble électronique 2 et la source d'énergie électrique 3 peut se faire à partir de bandes continues de matière plastique ou de carton mince, et il n'est pas nécessaire de séparer ces éléments les uns des autres à la fin de leur fabrication. Du fait de leur souplesse, ces bandes peuvent être enroulées sur des bobines, après la fabrication des éléments du dispositif, et ces bobines peuvent être stockées jusqu'au moment de l'assemblage du dispositif.

Il existerait ainsi des bobines contentant respectivement un grand nombre de cellules d'affichages, d'ensembles électroniques et de sources d'énergie électrique attenants les uns aux autres.

En outre, au cours de la fabrication de ces éléments, des adhésifs destinés à les réunir les uns aux autres de la manière décrite ci-dessus peuvent déjà être déposés aux emplacements voulus.

Pour éviter que ces adhésifs ne collent les spires des bobines les unes aux autres, il est posssible de les recouvrir d'une feuille de protection en matière plastique par exemple. Cette feuille de protection est bien entendu ôtée au moment de l'assemblage.

Pour éviter cette complication, il est possible d'utiliser pour les couches 41 à 44 de la figure 3 des adhésifs thermo-fusibles, qui sont solides à température normale et doivent être chauffés à une température déterminée pour jouer leur rôle d'adhésif.

La fig. 4 illustre schématiquement une machine pour l'assemblage de dispositifs selon l'invention à partir d'éléments fabriqués en bandes continues et présentés sous forme de bobines, et la fingure 5 montre quelques-uns de ces dispositifs tels qu'ils sortent, également en bande continue, de cette machine.

A la fig. 4, les références 51, 52 et 53 désignent respectivement les bobines de stockage des cellules d'affichage, des ensembles électroniques et des sources d'alimentation, fabriqués en bandes continues.

La machine d'assemblage comporte en outre deux rouleaux 54 et 55 destinés à entraîner les bandes provenant das bobines 51 à 53 en tournant dans le sens des flèches 54a et 55a sous l'action d'un organe moteur non représenté, et à appliquer ces bandes les unes contre le autres.

Si les adhésifs sur les bandes sont du type thermo-fusible, ces rouleaux peuvent être chauffés à une température suffisante pour que ces adhésifs fondent. En se refroidissant, après être passés entre les rouleaux 54 et 55, ces adhésifs se solidifient à nouveau et assurent les liaisons méchaniques et électriques entre les éléments des dispositifs, comme cela a été décrit ci-dessus.

Il est également possible de disposer des sources de chaleur, non représentées, avant les rouleaux 54 et 55, à proximité des bandes, pour faire fondre les adhésifs thermo-fusibles. Dans ce cas, les rouleaux 54 et 55 n'ont évidemment pas besoin d'être chauffés. Il peuvent même être refroidis pour accélérer le durcissement des adhésifs.

Si d'autres types d'adhésifs, nécessitant la présence d'une feuille de matière plastique ou de papier entre les spires des bobines 51, 52 et/ou 53, sont utilisés, il est possible de disposer, entre ces bobines et les rouleaux 54 et 55, d'autres bobines, non représentées, sur lesquelles ces feuilles de protection s'enroulent.

Il serait également possible de ne pas déposer d'adhésif sur les bandes au moment de leur fabrication et de placer un dispositif adéquat, non représenté, entre les bobines 51, 52 et 53 et les rouleaux 54 et 55 pour déposer ces adhésifs aux endroits voulus.

Les sources d'énergie électrique destinées à être assemblées avec les autres éléments du dispositif à l'aide d'une machine semblable à celle de la fig. 4 sont de préférence du type mentionné plus haut dans lequel l'électrolyte est contenu dans un récipient étanche qui doit être rompu pour que la source commence à fonctionner. La machine d'assemblage, et notamment les rouleaux 54 et 55, est en outre agencée de préférence de manière à éviter cette rupture. Les dispositifs assemblés, qui sortent en bande continue de la machine, peuvent ainsi être enroulés sur des bobines et stockés en état de non-fonctionnement jusqu'à leur mise en service. A ce moment-là, ils peuvent être séparés les uns des autres et le récipient contenant l'électrolyte de la source d'énergie électrique peut être rompu par une pression ou une torsion exercée sur le dispositif.

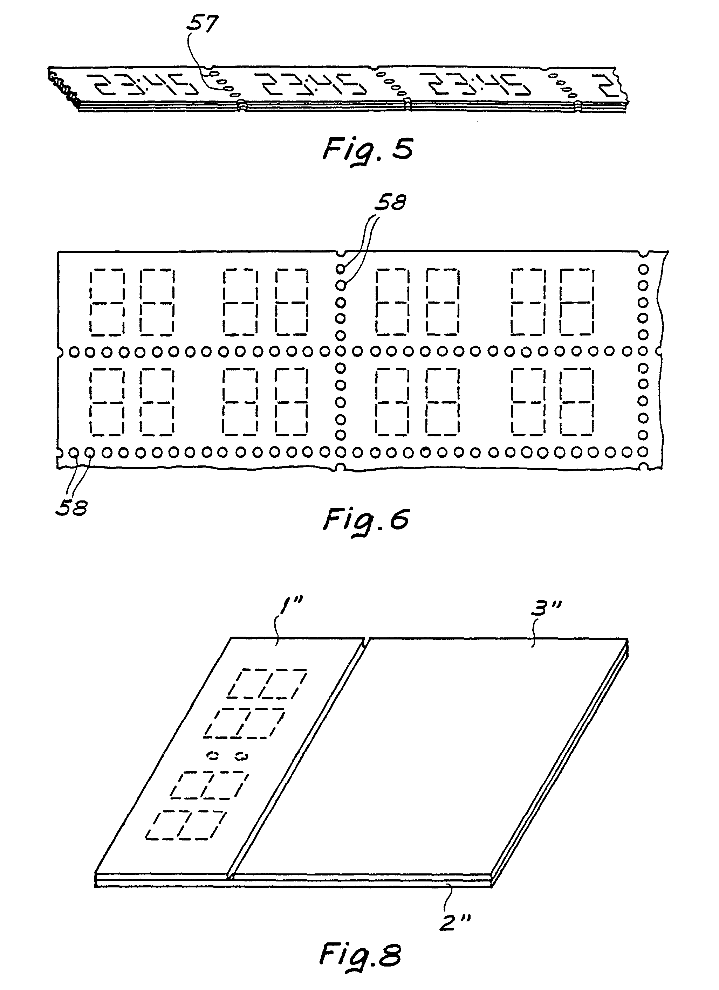

La fig. 5 montre des dispositifs tels qu'ils sortent dans ce cas, en bande continue, de la machine d'assemblage.

Il est cependant possible d'agencer les rouleaux 54 et 55 de manière que cette rupture ait lieu au moment de l'assemblage des éléments et de prévoir, dans la machine de la fig. 4, un mécanisme comprenant au moins un couteau et actionné en synchronisme avec la rotation des rouleaux 54 et 55 pour séparer les dispositifs les uns des autres. Un tel mécanisme de séparation est symbolisé à la fig. 4 par un couteau 56. Les dispositifs sortent alors de la machine d'assemblage séparés les uns des autres et en fonctionnement.

Les éléments constituant le dispositif selon l'invention doivent avoir une position relative bien déterminée lorsqu'ils passent entre les rouleaux 54 et 55.

Cette condition peut être facilement remplie en prévoyant dans chaque bande, entre les éléments consécutifs et/ou sur les bords de ces bandes, des trous qui coopèrent avec des dents ou des griffes, non représentées, disposées sur l'un ou l'autre des rouleaux 54 et pour entraîner ces bandes et positionner les éléments les uns par rapport aux autres.

Il est d'ailleurs également possible de prévoir un mécanisme d'entraînement, indépendant de ces rouleaux 54 et 55, qui utilise ces trous pour entraîner les trois bandes tout en maintenant leur position relative avec précision. Un tel mécanisme n'est pas représenté.

Les trous de positionnement et d'entraînement, qui sont représentés à la fig. 5 avec la référence 57, peuvent également servir comme amorce de rupture ou de déchirure pour permettre de séparer les dispositifs les uns des autres.

Enfin, il est bien entendu possible de munir la machine d'assemblage de la fig. 4 d'une quatrième bobine, non représentée, portant une bande de papier ou de matière plastique autocollante et sa feuille de protection. Cette bande autocollante pourrait ainsi être appliquée et fixée au dos des dispositifs en même temps que ceux-ci sont assemblés de la manière décrite ci-dessus.

Dans la bande de dispositifs représentée à la fig. 5, ceux-ci sont reliés par leur petit côté. Il est évident que ces dispositifs peuvent tout aussi bien être reliés par leur grand côté.

La fabrication de chacun des éléments du dispositif peut également se faire à partir de feuilles de grandes dimensions en matière plastique ou en carton mince, ces éléments étant disposés en plusieurs rangées et plusieurs colonnes sur ces feuilles. De nombreux dispositifs selon l'invention peuvent ainsi être fabriqués simultanément, en disposant une feuille contenant des cellules d'affichage et une feuille contenant des sources d'énergie électrique de part et d'autre d'une feuille contenant des ensembles électroniques. Les techniques d'assemblage, par collage par exemple, sont semblables à celles qui ont été décrites à l'aide de la fig. 3.

La fig. 6 montre une partie d'un ensemble de dispositifs selon l'invention fabriqués de la manière décrite ci-dessus, avant qu'ils ne soient séparés les uns des autres, par exemple par déchirure le long des trous désignés par 58. Ces trous 58 servent également à assurer un positionnement correct des différentes feuilles au moment de leur assemblage.

Les éléments 1, 2 et 3 formant le dispositif ont été représentés aux figures 1 et 2 avec des longueurs et des largeurs identiques. Ces dimensions pourraient bien entendu être différentes d'un élément à l'autre sans que le dispositif sorte du cadre de l'invention.

De même, la disposition relative des divers éléments du dispositif pourrait être différente de celle qui est représentée aux figures 1 et 2.

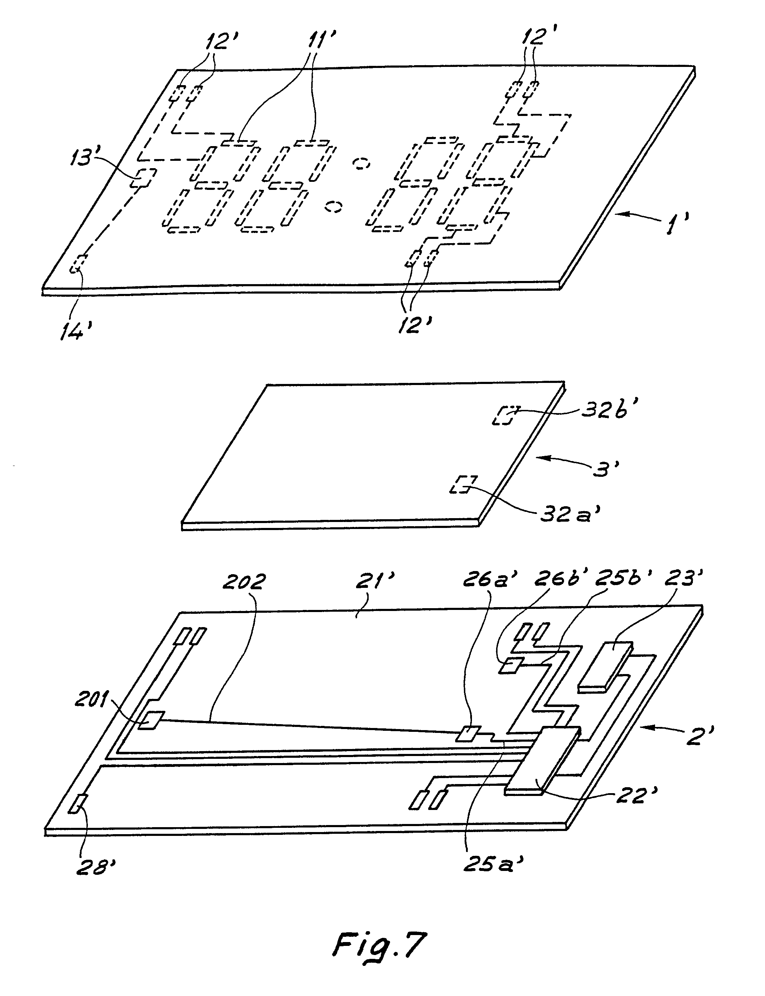

La fig. 7 représente, à titre d'exemple non limitatif, une vue éclatée d'un tel dispositif dans lequel la source d'énergie électrique, désignée par 3', est disposée entre la cellule d'affichage et l'ensemble électronique, désignés respectivement par 1' et 2'.

La cellule d'affichage 1' ne sera pas décrite ici, car elle est identique à la cellule 1 de la fig. 2. Ses diverses parties, désignées par les références 11'à 14', correspondent respectivement aux parties 11 à 14 de la cellule 1.

La source d'énergie électrique 3' est très semblable à la source 3 de la fig. 2. Dans cet exemple, sa largeur et sa longueur sont inférieures à la largeur et à la longueur de la cellule 1' et de l'ensemble électronique 2'. Ses bornes de connecion 32a' et 32b' sont disposées sur sa face inférieure. Contrairement à la source 3 de la fig. 2, elle ne comporte pas de plage de contact reliée à l'une de ces bornes.

L'ensemble électronique 2' est également très semblable à l'ensemble 2 de la fig. 2. Il comporte un circuit imprimé formé d'un substrat 21' portant des pistes conductrices, des bornes de connexion 27' disposées en regard des bornes 12' de la cellule d'affichage 1' et une borne de connexion 28' située en regard de la borne 14' de cette cellule 1'.

L'ensemble électronique 2' comporte également un circuit intégré 22' et un résonateur piézo-électrique 23', semblables aux composants correspondants de l'ensemble électronique 2 de la fig. 2. Ce circuit intégré 22' et ce résonateur 23' sont cependant disposés sur le substrat 21', et non pas dans des ouvertures ménagées dans celui-ci. Leurs bornes de connexion, non représentées, sont disposées sur leur face inférieure et sont appliquées contre les extrémités correspondantes des postes conductrices et connectées à celles-ci par l'un quelconque des procédés bien connus dans ce domaine.

Les bornes d'alimentation du circuit intégré 22' sont reliées par des pistes conductrices 25a' et 25b' à des bornes de connexion 26a' et 26b' situées sur la face supérieure du substrat 21', et non pas sur sa face inférieure comme dans l'exemple de la fig. 2, en regard des bornes 32a' et 32b' de la source d'énergie électrique 3'.

L'ensemble électronique 2' ne comporte donc pas de trous métallisés semblables aux trous 25c et 25d de l'ensemble électronique 2 de la fig. 2.

En outre, l'ensemble électronique 2' comporte une plage de contact 201 située en regard de la plage de contact 13' de la cellule d'affichage 1'. Cette plage de contact 201 est reliée à la borne de connexion 26a' par une piste conductrice 202.

L'assemblage et la connexion de la cellule d'affichage 1', de l'ensemble électronique 2' et de la source d'énergie électrique 3' pour réaliser un dispositif selon l'invention ne seront pas décrits en détail ici, car ils peuvent être réalisés de la même manière que dans le cas des figures 2 et 3, à la seule différence près que, dans le présent exemple, la source d'énergie électrique 3 est disposée entre la cellule d'affichage 1' et l'ensemble électronique 2'.

L'épaisseur de la source d'énergie électrique 3' étant généralement du même ordre de grandeur que celle du circuit intégré 22' et du résonateur 23', le dispositif assemblé est pratiquement plat.

Si le circuit intégré 22' et le résonateur 23', ou l'un des deux, sont nettement plus épais que la source d'énergie électrique 3', ils peuvent être logés dans des ouvertures, non représentées, ménagées dans la cellule d'affichage 1'.

Le fonctionnement du dispositif dans la forme d'exécution de la fig. 7 ne sera pas décrit en détail ici, car il est identique à celui du dispositif des figures 1 et 2. Comme dans ce dernier, l'utilisateur du dispositif peut modifier l'information affichée en appuyant sur la cellule d'affichage 3' dans la zone des plages de contact 13' et 201. La tension de la borne 32a' de la source d'énergie électrique 3' est ainsi appliquée à l'entrée du circuit de correction du circuit intégré 22' par l'intermédiaire de la borne de connexion 26a', des plages de contact 201 et 13' et des bornes de connexion 14' et 28'.

Dans une variante de la forme d'exécution du dispositif selon l'invention représentée à la fig. 7, le circuit intégré 22' et le résonateur 23' pourraient être disposés, comme dans l'exemple de la fig. 2, dans des ouvertures ménagées dans le subtrat 21, avec leurs bornes de connexion situées dans le plan de la face supérieure de ce substrat 21'. Cette variante n'est pas représentée.

Pour permettre d'assembler des dispositif selon la forme d'exécution de la fig. à l'aide d'une machine semblable à celle de la fig. 4, il suffit de donner aux feuilles de matière plastique ou de carton qui entourent les plaques et l'électrolyte de la source d'énergie électrique 3' une longueur égale à celle de la cellule d'affichage 1' et de l'ensemble électronique 2'. Dans ce cas, des ouvertures doivent bien entendu être ménagées dans ces feuilles de matière plastique ou de carton en regard du circuit intégré 22' et du résonateur 23', ainsi qu'en regard des plages de contact 13' et 201.

Il est également possible de disposer deux des éléments du dispositif côte à côte sur une même face du troisième élément. La fig. 8 représente schématiquement un tel dispositif dans lequel la cellule d'affichage et la source d'énergie électrique, respectivement désignées par 1'' et 3'', sont disposées côte à côte sur une des faces de l'ensemble électronique désigné par 2''. Cette fig. 8 ne sera pas décrite en détail, car la réalisation et l'assemblage des éléments 1'', 2'' et 3'' sont évidents à la lumière des explications qui ont été données ci-dessus.

Il est évident que, quelle que soit sa forme d'exécution, le dispositif selon l'invention peut être fixé à l'endroit où il doit être utilisé de n'importe laquelle des manières décrites pour la forme d'exécution des figures 1 et 2.

**Revendications**

1. Dispositif électronique pour élaborer et afficher une information, comportant trois éléments souples (1, 2, 3; 1', 2', 3; 1'', 2'', 3'') ayant chacun deux faces, respectivement constitués par un ensemble électronique (2; 2'; 2'') pour élaborer ladite information, une cellule d'affichage (1; 1'; 1'') pour afficher ladite information et une source d'énergie électrique (3; 3'; 3'') pour alimenter ledit ensemble électronique disposés de manière qu'au moins une face de chaque élément soit située en regard d'une face d'un autre élément, des moyens (41, 42) pour relier mécaniquement lesdits éléments (1, 2, 3; 1', 2', 3'; 1'', 2'', 3'') les uns aux autres, des moyens (43, 44) pour connecter électriquement lesdits éléments (1, 2, 3; 1', 2', 3'; 1'', 2'', 3'') les uns aux autres.

2. Dispositif selon la revendication 1, caractérisé par le fait que ledit ensemble électronique (2) est diposé entre ladite cellule d'affichage (1) et ladite source d'énergie électrique (3).

3. Dispositif selon la revendication 1, cacactérisé par le fait que ladite source d'énergie électrique (3') est disposée entre ladite cellule d'affichage (1') et ledit ensemble électronique (2').

4. Dispositif selon la revendication 1, caractérisé par le fait que deux desdits éléments sont disposés sur une même face du troisième élément.

5. Dispositif selon l'une des revendications 1 à 4, caractérisé par le fait que lesdits moyens de liaison mécanique (41, 42) comportent une couche d'adhésif isolant.

6. Dispositif selon la revendication 5, caractérisé par le fait que lesdits moyens de liaison électrique (43, 44) comportent une couche d'adhésif conducteur.

7. Dispositif selon la revendication 5, caractérisé par le fait que lesdits moyes de liaison électrique (43, 44) comportent une couche d'un matériau métallique fusible.

8. Dispositif selon la revendication 1, caractérisé par le fait qu'il comporte en outre des moyens pour modifier manuellement ladite information.

9. Dispositif selon la revendication 8, caractérisé par le fait que lesdits moyens de modification comportent un circuit électronique compris dans ledit ensemble électronique (2; 2') et une première et une deuxème plage de contact (13, 33; 13', 201) respectivement reliées à l'une des bornes (32a; 32a') de ladite source d'alimentation (3; 3') et audit circuit électronique et disposées chacune sur l'un desdits éléments en regard l'une de l'autre de manière à être normalement séparées et à venir en contact en réponse à une pression exercée sur le dispositif.

10. Dispositif selon la revendication 1, caractérisé par le fait qu'il comporte en outre des moyens (4) pour assurer sa fixation.

11. Dispositif selon la revendication 10, caractérisé par le fait que lesdits moyens (4) pour assurer sa fixation comportent une couche d'un matériau adhésif autocollant.

12. Procédé d'assemblage d'un dispositif selon la revendication 1, caractérisé par le fait qu'il consiste à munir au moins un desdits éléments de premiers moyens transformables en lesdits moyens de liaison mécanique (41, 42) et de deuxièmes moyens transformables en lesdits moyens de connexion électrique (43, 44), à appliquer lesdits éléments les uns contre les autres et à transformer lesdits premiers et deuxièmes moyens transformables pour produire respectivement lesdits moyens de liaison mécanique (41, 42) et lesdits moyens de connexion électrique (43, 44).

13. Procédé selon la revendication 12, caractérisé par le fait qu'il consiste en outre à munir ledit dispositif de moyens de fixation.

14. Procédé selon la revendication 12, caractérisé par le fait qu'il consiste en outre à produire lesdits éléments sous la forme de bandes comportant chacune une pluralité de d'un desdits éléments et des moyens (56) pour assurer le positionnement desdits éléments les uns par rapport aux autres.

15. Procédé selon la revendication 14, caractérisé par le fait qu'il consiste en outre à produire une bande comportant une pluralité de moyens de fixation et à appliquer lesdits moyens des fixation audit dispositif.

16. Procédé selon la revendication 12, caractérisé par le fait qu'il consiste en outre à produire lesdits éléments sous la forme de feuilles comportant chacune une pluralité de l'un desdits éléments et des moyens (57) pour assurer le positionnement desdits éléments les uns par rapport aux autres.

17. Machine pour la mise en oeuvre des étapes du procédé selon la revendication 14 qui consistent respectivement à appliquer lesdits éléments les uns contre les autres et à transformer lesdits moyens transformables, lesdits éléments ayant été préalablement produits sous la forme desdites bandes et munis desdits premiers et deuxièmes moyens transformables, caractérisée par le fait qu'elle comporte des moyens de support desdites bandes, des moyens coopérant avec lesdits moyens de positionnement pour appliquer lesdites bandes les unes contres les autres de manière que chaque élément d'une bande soit appliqué contre un élément de l'une des autres bandes, et des moyens pour transformer lesdits moyens transformables.

18. Machine selon la revendication 17, caractérisée par le fait qu'elle comporte en outre des moyens de support d'une bande comportant une pluralité de moyens de fixation, lesdits moyens pour appliquer les bandes d'éléments les unes contre les autres étant agencés de manière à appliquer en outre ladite bande de moyens de fixation contre l'une desdites bandes d'éléments.

**Patentansprüche**

1. Elektronische Vorrichtung zum Erarbeiten und Anzeigen einer Information, umfassend drei jeweils zweiseitige flexible Elemente (1, 2, 3; 1', 2', 3'; 1'', 2'', 3''), bestehend aus einer elektronischen Einheit (2; 2'; 2'') zum Erarbeiten der genannten Information, einer Anzeigezelle (1; 1'; 1'') zum Anzeigen der genannten Information und einer elektrischen Energiequelle (3; 3'; 3'') zum Speisen der genannten elektronischen Einheit, die so angeordnet sind, dass mindestens eine Seite jeden Elementes einer Seite eines anderen Elementes zugewandt ist, Mittel (41, 42) zur mechanischen Verbindung der genannten Elemente (1, 2, 3; 1', 2', 3'; 1'', 2'', 3'') untereinander, und Mittel (43, 44) zur elektrischen Verbindung der genannten Elemente (1, 2, 3; 1', 2', 3'; 1'', 2'', 3'') untereinander.

2. Vorrichtung nach Anspruch 1, dadurch gekennzeichnet, dass die genannte elektronische Einheit (2) zwischen der genannten Anzeigezelle (1) und der genannten elektrischen Speisequelle (3) angeordnet ist.

3. Vorrichtung nach Anspruch 1, dadurch gekennzeichnet, dass die genannte elektrische Energiequelle (3') zwischen der genannten Anzeigezelle (1') und der genannten elektronischen Einheit (2') angeordnet ist.

4. Vorrichtung nach Anspruch 1, dadurch gekennzeichnet, dass zwei der genannten Elemente auf derselben Seite des dritten Elements angeordnet sind.

5. Vorrichtung nach Anspruch 1 bis 4, dadurch gekennzeichnet, dass die genannten mechanischen Verbindungsmittel (41, 42) eine Schicht isolierenden Klebers umfassen.

6. Vorrichtung nach Anspruch 5, dadurch gekennzeichnet, dass die genannten elektrischen Verbindungsmittel (43, 44) eine Schicht leitenden Klebers umfassen.

7. Vorrichtung nach Anspruch 5, dadurch gekennzeichnet, dass die genannten elektrischen Verbindungsmittel (43, 44) eine Schicht eines schmelzbaren metallischen Materials umfassen.

8. Vorrichtung nach Anspruch 1, dadurch gekennzeichnet, dass sie ferner Mittel zur manuellen Änderung der genannten Information umfasst.

9. Vorrichtung nach Anspruch 8, dadurch gekennzeichnet, dass die genannten Änderungsmittel einen in der genannten elektronischen Einheit (2; 2') einbezogenen elektronischen Schaltkreis umfassen sowie einen ersten und einen zweiten Kontaktbereich (13, 33; 13', 201), die jeweils mit einem der Anschlüsse (32a; 32a') der genannten Speisequelle (3; 3') und mit dem genannten Schaltkreis verbunden sind und gegenüberliegend so auf je einem der genannten Elemente angeordnet sind, dass sie normalerweise getrennt sind und dann in Kontakt treten, wenn ein Druck auf die Vorrichtung ausgeübt wird.

10. Vorrichtung nach Anspruch 1, dadurch gekennzeichnet, dass sie Mittel (4) zu ihrer Befestigung umfasst.

11. Vorrichtung nach Anspruch 10, dadurch gekennzeichnet, dass die genannten Mittel (4) zu ihrer Befestigung eine Schicht eines selbstklebenden Bindematerials umfassen.

12. Verfahren zur Zusammenfügung einer Vorrichtung nach Anspruch 1, dadurch gekennzeichnet, dass es darin besteht, mindestens eines der genannten Elemente mit ersten in die genannten mechanischen Verbindungsmittel (41, 42) umwandelbaren Mitteln und mit zweiten in die genannten elektrischen Verbindungsmittel (43, 44) umwandelbaren Mitteln auszustatten, die genannten Elemente gegeneinander aufzusetzen und die genannten ersten und zweiten umwandelbaren Mittel umzuwandeln, um jeweils die genannten mechanischen Verbindungsmittel (41, 42) und die genannten elektrischen Verbindungsmittel (43, 44) zu erzeugen.

13. Verfahren nach Anspruch 12, dadurch gekennzeichnet, dass es ferner darin besteht, die genannte Vorrichtung mit Befestigungsmitteln auszustatten.

14. Verfahren nach Anspruch 12, dadurch gekennzeichnet, dass es ferner darin besteht, die genannten Elemente in Form von Bändern zu erzeugen, die jeweils eine Vielzahl eines der genannten Elemente sowie Mittel (56) enthalten, um die gegenseitige Positionierung der genannten Elemente zu gewährleisten.

15. Verfahren nach Anspruch 14, dadurch gekennzeichnet, dass es ferner darin besteht, ein eine Vielzahl von Befestigungsmitteln umfassendes Band zu erzeugen und die genannten Befestigungsmittel auf die genannte Vorrichtung aufzusetzen.

16. Verfahren nach Anspruch 12, dadurch gekennzeichnet, dass es ferner darin besteht, die genannten Elemente in Form von Folien zu erzeugen, die jeweils eine Vielzahl eines der genannten Elemente umfassen und Mittel (57), die die gegenseitige Positionierung der genannten Elemente gewährleisten.

17. Maschine zur Durchführung jener Stufen des Verfahrens nach Anpruch 14, die jeweils darin bestehen, die genannten Elemente gegeneinander aufzusetzen und die genannten umwandelbaren Mittel umzuwandeln, wobei die genannten Elemente zuvor in Form der genannten Bänder erzeugt und mit den genannten ersten und zweiten umwandelbaren Mitteln ausgestattet wurden, dadurch gekennzeichnet, dass sie Mittel zum Tragen der genannten Bänder umfasst, sowie Mittel, die mit den genannten Positionierungsmitteln zum gegenseitigen Aufsetzen der genannten Bänder zusammenwirken, so dass jedes Element eines Bandes auf ein Element eines der anderen Bänder aufgesetzt wird, und Mittel zur Umwandlung der genannten umwandelbaren Mittel.

18. Maschine nach Anspruch 17. dadurch gekennzeichnet, dass sie ferner Tragemittel für eines eine Vielzahl von Befestigungsmitteln umfassenden Bandes umfasst, wobei die genannten Mittel zum gegenseitigen Aufsetzen der Elementebänder so gestaltet sind, dass das genannte die Befestigungsmittel tragende Band ferner auf eines der genannten Elementebänder aufgesetzt wird.

**Claims**

1. Electronic arrangement for elaborating and displaying information including three supple elements (1, 2, 3; 1', 2', 3'; 1'', 2'', 3'') each having two faces respectively constituted by an electronic assembly (2; 2'; 2'') for elaborating said information, a display cell (1; 1'; 1'') for displaying said information and a source of electrical energy (3; 3'; 3'') for energizing said electronic assembly arranged so that at least one face of each element is located opposite a face of another element, means (41, 42) for mechanically coupling said elements (1, 2, 3; 1', 2', 3'; 1'', 2'', 3'') to one another and means (43, 44) for electrically connecting said elements (1, 2, 3; 1', 2', 3'; 1'', 2'', 3'') to one another.

2. Arrangement according to claim 1 characterized by the fact that said electronic assembly (2) is placed between said display cell (1) and said source of electrical energy (3).

3. Arrangement according to claim 1 characterized by the fact that said source of electrical energy (3') is placed between said display cell (1') and said electronic assembly (2').

4. Arrangement according to claim 1 characterized by the fact that two of said elements are placed on a same face of the third element.

5. Arrangement according to any of claims 1 to 4 characterized by the fact that said mechanical coupling means (41, 42) include a layer of insulating adhesive.

6. Arrangement according to claim 5 characterized by the fact that said electrical coupling means (43, 44) include a layer of conducting adhesive.

7. Arrangement according to claim 5 characterized by the fact that said electrical coupling means (43, 44) include a layer of meltable metallic material.

8. Arrangement according to claim 1 characterized by the fact that it includes furthermore means for manually modifying said information.

9. Arrangement according to claim 8 characterized by the fact that said modification means include an electronic circuit comprised in said electronic assembly (2; 2') and a first and a second contact area (13, 33; 13', 20') respectively coupled to one of the terminals (32a; 32a') of said source of electrical energy (3; 3') and to said electronic circuit and each placed on one of said elements facing one of the other in a manner to be normally separated and to come into contact in response to pressure exerted on the arrangement.

10. Arrangement according to claim 1 characterized by the fact that it includes furthermore means (4) to assure its fastening.

11. Arrangement according to claim 10 characterized by the fact that said means for assuring its fastening include a layer of self-sticking adhesive material.

12. Process for the assembly of an arrangement according to claim 1 characterized by the fact that it consists in providing at least one of said elements with first means transformable into said mechanical coupling means (41, 42) and with second means transformable into said electrical connection means (43, 44), in applying said elements against one another and in transforming said first and second transformable means so as to produce respectively said mechanical coupling means (41, 42) and said electrical connection means (43, 44).

13. Process according to claim 12 characterized by the fact that it consists furthermore in providing said arrangement with fastening means.

14. Process according to claim 12 characterized by the fact that it consists furthermore in producing said elements in the form of tapes each including a plurality of one of said elements and means (56) for assuring the positioning of said elements with reference to one another.

15. Process according to claim 14 characterized by the fact that it consists furthermore in producing a tape including a plurality of fastening means and in applying said fastening means to said arrangement.

16. Process according to claim 12 characterized by the fact that it consists furthermore in producing said elements in the form of sheets each including a plurality of one of said elements and means (57) for assuring the positioning of said elements with reference to one another.

17. Machine for carrying out the stages of the process according to claim 14 which consist respectively in applying said elements againt one another and in transforming said transformable means, said elements having been initially produced in the form of said tapes and provided with said first and second transformable means characterized by the fact that it includes support means for said tapes, means cooperating with said positioning means for applying said tapes against one another so that each element of a tape is applied against an element of one of the other tapes and means for transforming said transformable means.

18. Machine according to claim 17 characterized by the fact that it includes furthermore means for supporting a tape including a plurality of fastening means, said means for applying the element tapes against one another being arranged so as to apply furthermore said fastening means tape against one of said element tapes.

*Fig. 1*

*Fig. 3*

Fig. 2

Fig. 4

57

Fig. 5

58

58

Fig.6

1"

3"

2"

Fig.8

Fig.7